# EUROPEAN PATENT APPLICATION

(11) **EP 4 730 024 A1**
(43) Date of publication of application: **22.04.2026**
(21) Application number: 24923282.8
(22) Date of filing: 30.08.2024
(51) Int. Cl.: G02F 1/1333

(54) **DISPLAY DEVICE AND FRAME ASSEMBLY**

(30) Priority: 06.02.2024 CN 202410173499; 11.03.2024 CN 202410278202
(71) Applicant: Huawei Technologies Co., Ltd., Shenzhen, Guangdong 518129 (CN)
(72) Inventor: LI, Yunchao, Shenzhen, Guangdong 518129 (CN); HUANG, Tai, Shenzhen, Guangdong 518129 (CN); HAN, Dongdong, Shenzhen, Guangdong 518129 (CN); XU, Jintao, Shenzhen, Guangdong 518129 (CN); ZHAO, Fuliang, Shenzhen, Guangdong 518129 (CN)
(74) Representative: MERH-IP Matias Erny Reichl Hoffmann Patentanwälte PartG mbB
(86) International application number: PCT/CN2024/116006
(87) International publication number: WO 2025/167072

(57) **Abstract**

A display apparatus (100) and a frame assembly (102) are disclosed. The display apparatus (100) includes a display structure (101), a frame (105), and a cover plate (106). The frame (105) is disposed on a periphery of the display structure (101). The cover plate (106) includes a first part (1061) and a second part (1062) that are connected, the first part (1061) is located on a side of a display surface of the display structure (101), and the second part (1062) is disposed opposite to the frame (105). In addition, the second part (1062) of the cover plate (106) includes a first segment (106A) and a second segment (106B). Space (107) for avoiding a mechanical part is formed between the first segment (106A) and a reference plane (plane L) and between the second segment (106B) and the reference plane (plane L). A spacing (S1) between the first segment (106A) and the reference plane (plane L) is greater than a spacing (S2) between the second segment (106B) and the reference plane (plane L). A plane perpendicular to the display surface of the display structure (101) is the reference plane (plane L). For example, when the mechanical part is a circuit board (108), the large space between the first segment (106A) and the reference plane (plane L) can provide large bending avoidance space for the circuit board (108) during bending, to ensure a safety clearance.

## Description

This application claims priorities to Chinese Patent Application No. 202410173499.X, filed with the China National Intellectual Property Administration on February 6, 2024 and entitled "SCREEN NARROW FRAME STRUCTURE AND SCREEN", and to Chinese Patent Application No. 202410278202.6, filed with the China National Intellectual Property Administration on March 11, 2024 and entitled "DISPLAY APPARATUS AND FRAME ASSEMBLY", both of which are incorporated herein by reference in their entireties.

### TECHNICAL FIELD

This application relates to the field of display technologies, and in particular, to a display apparatus and a frame assembly that may be used in the display apparatus.

### BACKGROUND

Display electronic devices, such as televisions and computers, have been widely used. With continuous development of technologies and continuous improvement of people's living standards, a narrow frame and a high screen-to-body ratio of such electronic devices have gradually become a development trend to meet a large-screen requirement of people for a display and a pursuit of aesthetics of the electronic devices.

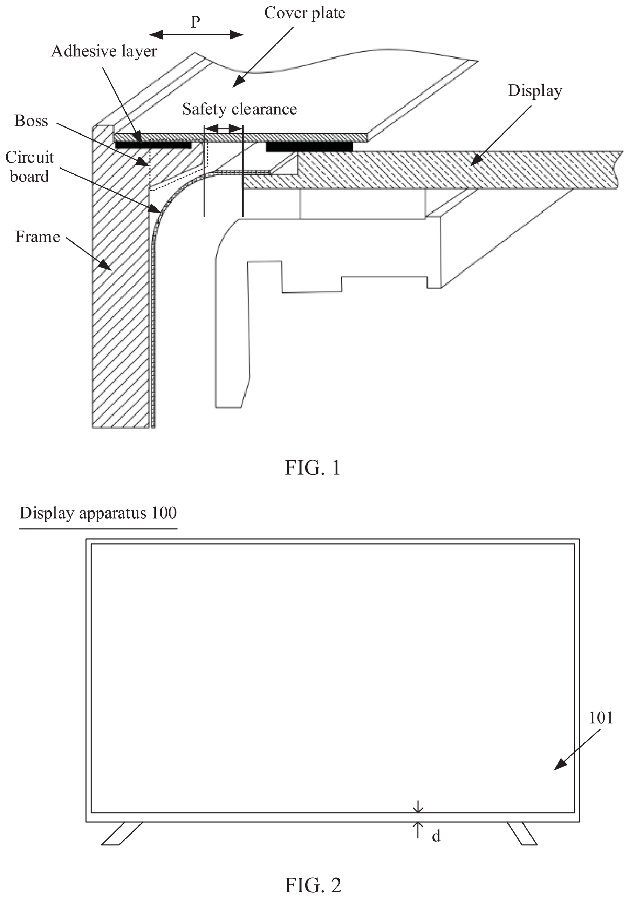

FIG. 1 is an example diagram of a partial structure of a display apparatus in the conventional technology. The display apparatus may include a frame, and a cover plate that can protect a display. The cover plate is bonded to the frame through an adhesive layer manufactured by using a gel dispensing process.

To connect the cover plate and the frame, as shown in FIG. 1, the frame has a boss, and the cover plate is supported on the boss. In addition, a circuit board is connected to the display, and the circuit board needs to be bent. As shown in FIG. 1, the circuit board needs to have a safety clearance when being bent. However, in FIG. 1, the boss of the frame occupies safety clearance space of the circuit board. To make the circuit board meet a design requirement on the safety clearance, the display apparatus has a large size in a P direction shown in FIG. 1. As a result, it is difficult to implement a narrow frame and a high screen-to-body ratio of the display apparatus.

### SUMMARY

This application provides a display apparatus and a frame assembly that may be used in the display apparatus, to reduce a frame size of the display apparatus and implement a narrow frame and a high screen-to-body ratio.

To achieve the foregoing objective, the following technical solutions are used in embodiments of this application.

According to one aspect, this application provides a display apparatus. For example, the display apparatus may be an apparatus like a television, a tablet computer, a notebook computer, or a desktop computer, and the display apparatus may be an apparatus whose screen size is greater than or equal to 14 inches.

The display apparatus includes a display structure, a frame, and a cover plate. The frame is disposed on a periphery of the display structure. The cover plate includes a first part and a second part, the first part is located on a side of a display surface of the display structure, and the second part is disposed opposite to the frame.

In addition, the second part of the cover plate includes a first segment and a second segment. Space for avoiding a mechanical part is formed between the first segment and a reference plane and between the second segment and the reference plane. A spacing between the first segment and the reference plane is greater than a spacing between the second segment and the reference plane. A plane perpendicular to the display surface of the display structure is the reference plane.

In the display apparatus provided in this application, the cover plate includes not only the first part disposed on the side of the display surface of the display structure, but also the second part disposed opposite to the frame. For example, the first part may be used as a protection structure to protect the display structure, and the second part may be connected to the frame. In addition, in the display apparatus provided in this application, the space for avoiding the mechanical part is formed between the first segment of the cover plate and the reference plane and between the second segment and the reference plane. For example, space for avoiding a circuit board may be provided. In addition, the spacing between the first segment of the cover plate and the reference plane is greater than the spacing between the second segment and the reference plane. In this way, space for accommodating a bent part of the circuit board is larger than space for accommodating an extended part of the circuit board. In this way, sufficient bending space can be provided for the circuit board, and the large bending space ensures a safety clearance of the circuit board. Therefore, in the solution provided in this application, the safety clearance of the mechanical part (for example, the circuit board) and a connection structure between the cover plate and the frame may be decoupled, so that space occupied by the connection structure and the safety clearance do not change in an inverse proportion. In this way, a frame size can be reduced while ensuring the safety clearance of the circuit board, to implement a narrow frame and a high screen-to-body ratio.

In a possible implementation, the first segment and the second segment are consecutive segments of the second part, the first segment is closer to the first part than the second segment, and an included angle between the first part and the second part is less than 90°.

The first part and the second part of the cover plate form an included angle less than 90°, in other words, the second part is disposed at an angle, so that the spacing between the first segment and the reference plane is greater than the spacing between the second segment and the reference plane.

In an example of the display apparatus in this application, the second part that is of the cover plate and that is disposed opposite to the frame is disposed at an angle. Alternatively, it may be understood as follows: In a direction from a back surface of the display structure to the display surface, a spacing between a side surface of the display structure and the second part of the cover plate is larger at a position closer to the display structure. In this way, more bending space can be reserved for the circuit board, ensuring the safety clearance of the circuit board.

In a possible implementation, the frame includes a first side surface and a second side surface that are opposite to each other, and the first side surface is closer to the second part than the second side surface. A distance between the first side surface and the second side surface decreases in the direction from the back surface of the display structure to the display surface, so that the first side surface is an inclined surface, and the second part is disposed at an angle on the inclined surface, so that the spacing between the first segment and the reference plane is greater than the spacing between the second segment and the reference plane.

In this embodiment, a spacing between the first side surface and the second side surface that are of the frame and that are opposite to each other gradually decreases in the direction from the back surface of the display structure to the display surface. In other words, the frame is in a wedge-shaped structure. In this way, the accommodation space of the bent part of the circuit board can also be greater than the accommodation space of the extended part.

In addition, an exposed part that is of the frame and that is visible to a user is narrow, resulting in a narrowing effect for both the frame and the cover plate that form the structure.

In a possible implementation, the second part of the cover plate includes a third side surface and a fourth side surface that are opposite to each other, the third side surface is parallel to the fourth side surface, and the third side surface is disposed opposite to the first side surface.

In a possible implementation, the second part includes a third side surface and a fourth side surface that are opposite to each other, and the fourth side surface is closer to the frame than the third side surface. A distance between the third side surface and the fourth side surface decreases in the direction from the back surface of the display structure to the display surface, so that the third side surface is an inclined surface, and the spacing between the first segment and the reference plane is greater than the spacing between the second segment and the reference plane.

In this example, the second part of the cover plate is in a wedge-shaped structure.

In a possible implementation, the second part of the cover plate is in a wedge-shaped structure, the frame includes a first side surface and a second side surface that are opposite to each other, and the first side surface is parallel to the second side surface.

In a possible implementation, the second part of the cover plate includes a first end connected to the first part and a second end opposite to the first end, and both the first segment and the second segment are located between the first end and the second end. A side surface that is of the first end and that faces the frame is attached to the frame.

It may be understood as that the cover plate is seamlessly connected to the frame when viewed from an appearance of the display apparatus. In this way, appearance aesthetics of the display apparatus can be improved.

In a possible implementation, the second part of the cover plate includes the first end connected to the first part and the second end opposite to the first end. The side surface that is of the first end and that faces the frame is attached to the frame. In the direction from the back surface of the display structure to the display surface, a surface that is of the frame and that is attached to the first end inclines in a direction away from a side surface of the display structure.

A surface that is of the frame and that is attached to the cover plate is designed as an inclined surface. In this way, during assembly, even if there is an assembly tolerance, the inclined surface can weaken a visual effect of the tolerance gap compared with a vertical surface, to improve appearance aesthetics.

In a possible implementation, the display apparatus further includes an adhesive layer, the adhesive layer connects the frame to the second part, and the adhesive layer is disposed on a side that is away from the frame and that is attached to the cover plate.

For example, the adhesive layer may be disposed between the first end and the second end of the second part.

In this example, the cover plate is seamlessly connected to the frame when viewed from an appearance of the display apparatus, and the adhesive layer is hidden inside the display apparatus. On the basis of ensuring strength of a connection between the frame and the cover plate, appearance aesthetics of the display device may be further optimized.

In a possible implementation, a side surface that is of the second end and that faces the frame is attached to the frame.

In a possible implementation, a groove is disposed at a position that is of the frame and that is opposite to the second part, and the adhesive layer is located in the groove.

The groove is disposed, and the adhesive layer is disposed in the groove, so that the frame size can be further reduced.

In a possible implementation, a glue overflow groove is disposed on a bottom surface that is of the groove and that is opposite to the second part.

For example, when the adhesive layer is manufactured by using a gel dispensing process, the glue overflow groove may be used to accommodate flowing glue, to reduce a risk that the glue flows to another position.

In a possible implementation, a boss is formed on a side surface that is of the frame and that faces the circuit board. The boss is disposed at a position that is away from the frame and that is attached to the cover plate. The boss is configured to limit a mounting position of the second part, and the second end of the second part is located above the boss.

The boss is disposed, so that a mounting position of the cover plate can be limited. In addition, in some scenarios, a gap between the first part of the cover plate and the display structure may be adjusted based on different design requirements. For example, when a designed gap between the first part of the cover plate and the display structure is large, the cover plate may be moved upward to increase the gap. Alternatively, when a designed gap between the first part of the cover plate and the display structure is small, the cover plate may be moved downward to reduce the gap. In this way, adaptation between a frame assembly (including the frame and the cover plate) and the display structure can be improved.

In a possible implementation, the frame includes a fitting part opposite to the second part, and further includes an elongated part connected to the fitting part, and a side surface that is of the elongated part and that faces the mechanical part protrudes relative to a side surface that is of the second part and that faces the mechanical part.

When the cover plate is mounted, the cover plate may be adjusted upward and downward along the frame, and a side surface that is of the cover plate and that faces the circuit board does not exceed a side surface of the frame. In this way, when the cover plate is adjusted, the circuit board can be protected, and the circuit board is less likely to be scratched by the movable cover plate.

In a possible implementation, there is a protective layer on the side surface that is of the second part and that faces the mechanical part and/or the side surface that is of the elongated part and that faces the mechanical part.

The protective layer may be used to protect the circuit board. For example, the protective layer may be made of a Mylar material.

In a possible implementation, the first segment and the second segment are nonconsecutive segments of the second part, the first segment and the second segment are connected through a connecting segment, and the first segment is closer to the first part than the second segment; and a first concave cavity is formed at a position of the first segment of the cover plate, so that the spacing between the first segment and the reference plane is greater than the spacing between the second segment and the reference plane.

For example, the first concave cavity is disposed opposite to the bent part of the circuit board, and the first concave cavity may accommodate the bent part, to provide larger space for the bent part and ensure a safety clearance of the bent part.

In a possible implementation, a second concave cavity is formed at a position that is of the frame and that corresponds to the first segment, and the first segment is located in the second concave cavity.

Because a concave cavity is disposed on the frame, an exposed part that is of the frame and that is visible to a user is narrow, resulting in a narrowing effect for both the frame and the cover plate that form the structure.

In a possible implementation, the display apparatus further includes an adhesive layer, and the adhesive layer connects the second segment to the frame.

In a possible implementation, the mechanical part includes the circuit board, the circuit board is located on an inner side of the cover plate, the circuit board is connected to the display structure, the circuit board bends and extends toward the back surface of the display structure, and the space between the first segment and the reference plane and between the second segment and the reference plane is for avoiding the circuit board.

In some other examples, the mechanical part may alternatively be another structure.

In a possible implementation, the frame is a bottom frame.

In some structures, the display apparatus further includes another frame, and the another frame is connected to the bottom frame to form a frame structure of the display apparatus.

According to another aspect, this application provides a frame assembly, and the frame assembly may be used in a display module, for example, may be used in an apparatus like a television, a tablet computer, a notebook computer, or a desktop computer.

The frame assembly includes a frame and a cover plate. The frame is configured to be disposed on a periphery of a display structure of a display apparatus. The cover plate includes a first part and a second part that are connected, the first part is configured to be disposed on a side of a display surface of the display structure, the second part is disposed opposite to the frame, an included angle between the first part and the second part is less than 90°, the second part includes a first segment and a second segment, the first segment and the second segment are consecutive segments of the second part, and space for avoiding a mechanical part in the display apparatus is formed between the first segment and a reference plane and between the second segment and the reference plane. A spacing between the first segment and the reference plane is greater than a spacing between the second segment and the reference plane. A plane perpendicular to the display surface of the display structure is the reference plane.

The frame assembly is used in the display apparatus. The display apparatus may include a circuit board electrically connected to the display structure. The circuit board needs to be bent to a side of a back surface of the display structure. In the frame assembly, the second part that is of the cover plate and that is disposed opposite to the frame is disposed at an angle, which may be understood as follows: In a direction from the back surface of the display structure to the display surface, a spacing between a side surface of the display structure and the second part of the cover plate is larger at a position closer to the display structure. In this way, more bending space can be reserved for the circuit board, ensuring a safety clearance of the circuit board.

In a possible implementation, the frame includes a first side surface and a second side surface that are opposite to each other, and the first side surface is closer to the second part than the second side surface. A distance between the first side surface and the second side surface decreases in the direction from the back surface of the display structure to the display surface, so that the first side surface is an inclined surface, and the second part is disposed at an angle on the inclined surface, so that the spacing between the first segment and the reference plane is greater than the spacing between the second segment and the reference plane.

In this example, the frame is in a wedge-shaped structure. In this way, larger accommodation space can be provided for a bent part of the circuit board, to ensure a safety clearance of the bent part.

In a possible implementation, the second part includes a first end connected to the first part and a second end opposite to the first end, and both the first segment and the second segment are located between the first end and the second end. A side surface that is of the first end and that faces the frame is attached to the frame.

In this way, the cover plate is seamlessly connected to the frame when viewed from an appearance of the display apparatus, so that appearance aesthetics of the display apparatus can be improved.

In a possible implementation, the frame assembly further includes an adhesive layer, the adhesive layer connects the frame to the second part, and the adhesive layer is disposed on a side that is away from the frame and that is attached to the cover plate.

The adhesive layer is hidden inside, so that appearance aesthetics of the display apparatus can be further optimized.

In a possible implementation, a groove is disposed at a position that is of the frame and that is opposite to the second part, and the adhesive layer is located in the groove.

The groove is disposed, and the adhesive layer is disposed in the groove, so that a frame size can be further reduced.

In a possible implementation, a glue overflow groove is disposed on a bottom surface that is of the groove and that is opposite to the second part.

For example, when the adhesive layer is manufactured by using a gel dispensing process, the glue overflow groove may be used to accommodate flowing glue, to reduce a risk that the glue flows to another position.

In a possible implementation, a boss is formed on a side surface that is of the frame and that faces the circuit board. The boss is disposed at a position that is away from the frame and that is attached to the cover plate. The boss is configured to limit a mounting position of the second part, and the second end of the second part is located above the boss.

The boss is disposed, so that a mounting position of the cover plate can be limited. In addition, in some scenarios, a gap between the first part of the cover plate and the display structure may be adjusted based on different design requirements. For example, when a designed gap between the first part of the cover plate and the display structure is large, the cover plate may be moved upward to increase the gap. Alternatively, when a designed gap between the first part of the cover plate and the display structure is small, the cover plate may be moved downward to reduce the gap. In this way, adaptation between a frame assembly (including the frame and the cover plate) and the display structure can be improved.

In a possible implementation, the frame includes a fitting part opposite to the second part, and further includes an elongated part connected to the fitting part, and the elongated part protrudes relative to the second part.

When the cover plate is mounted, the cover plate may be adjusted upward and downward along the frame, and a side surface that is of the cover plate and that faces the circuit board does not exceed a side surface of the frame. In this way, when the cover plate is adjusted, the circuit board can be protected, and the circuit board is less likely to be scratched by the movable cover plate.

In a possible implementation, there is a protective layer on a side surface that is of the second part and that faces the circuit board and/or a side surface that is of the elongated part and that faces the circuit board.

The protective layer may be used to protect the circuit board.

In a possible implementation, the frame is a bottom frame in the display apparatus.

According to still another aspect, this application provides a frame assembly, and the frame assembly may be used in a display module.

The frame assembly includes a frame and a cover plate. The frame is configured to be disposed on a periphery of a display structure of a display apparatus. The cover plate includes a first part and a second part that are connected, the first part is configured to be disposed on a side of a display surface of the display structure, the second part is disposed opposite to the frame, the second part includes a first segment, a second segment, and a connecting segment connecting the first segment and the second segment, and space for avoiding a mechanical part in the display apparatus is formed between the first segment and a reference plane and between the second segment and the reference plane. A first concave cavity is formed at a position of the first segment of the cover plate, so that a spacing between the first segment and the reference plane is greater than a spacing between the second segment and the reference plane. A plane perpendicular to the display surface of the display structure is the reference plane.

The frame assembly is used in the display apparatus. The display apparatus may include a circuit board electrically connected to the display structure. The circuit board needs to be bent to a side of a back surface of the display structure. The first concave cavity is disposed opposite to a bent part of the circuit board, and the first concave cavity may accommodate the bent part, to provide larger space for the bent part and ensure a safety clearance of the bent part.

In a possible implementation, a second concave cavity is formed at a position that is of the frame and that corresponds to the first segment, and the first segment is located in the second concave cavity.

In a possible implementation, the frame assembly further includes an adhesive layer, and the adhesive layer connects the second segment to the frame.

In a possible implementation, there is a protective layer on a side surface that is of the second segment and that faces the circuit board.

The protective layer may be used to protect the circuit board.

In a possible implementation, the frame is a bottom frame.

### BRIEF DESCRIPTION OF DRAWINGS

FIG. 1 is a diagram of a structure of a frame and a cover plate in a display apparatus in the conventional technology;
FIG. 2 is a diagram of an appearance and a structure of a display apparatus according to an embodiment of this application;
FIG. 3 is a schematic exploded view of a display apparatus according to an embodiment of this application;
FIG. 4 is a cross-sectional view obtained after cutting along A-A in FIG. 3;
FIG. 5 is a diagram of an assembly structure of a frame, a cover plate, and another structure in a display apparatus according to an embodiment of this application;
FIG. 6 is a diagram of an assembly structure of a frame, a cover plate, and another structure in a display apparatus according to an embodiment of this application;
FIG. 7 is a diagram of an assembly structure of a frame, a cover plate, and a display structure in a display apparatus according to an embodiment of this application;
FIG. 8 is a diagram of an assembly structure of a frame, a cover plate, and a display structure in a display apparatus according to an embodiment of this application;
FIG. 9 is an exploded view of a frame and a cover plate in a display apparatus according to an embodiment of this application;
FIG. 10 is an exploded view of a frame and a cover plate in a display apparatus according to an embodiment of this application;
FIG. 11 is an exploded view of a frame and a cover plate in a display apparatus according to an embodiment of this application;
FIG. 12 is a diagram of a connection relationship between a frame and a cover plate in a display apparatus according to an embodiment of this application;
FIG. 13 is an exploded view of a frame and a cover plate in a display apparatus according to an embodiment of this application;
FIG. 14 is a diagram of a connection relationship between a frame and a cover plate in a display apparatus according to an embodiment of this application;
FIG. 15 is a diagram of a connection relationship between a frame and a cover plate in a display apparatus according to an embodiment of this application;
FIG. 16 is a diagram of an assembly structure of a frame, a cover plate, and a display structure in a display apparatus according to an embodiment of this application;
FIG. 17 is a diagram of an assembly structure of a frame, a cover plate, and a display structure in a display apparatus according to an embodiment of this application; and
FIG. 18 is an exploded view of a frame and a cover plate in a display apparatus according to an embodiment of this application.

Reference numerals:
100: display apparatus;
101: display structure; 102: frame assembly; 103: rear cover; 104: backplane; 105: frame; 106: cover plate; 107: space; 108: circuit board; 109: adhesive layer; 110: glue overflow groove; 111: boss; 112: protective layer; 113: first concave cavity; 114: second concave cavity;
1011: lower polarizer; 1012: substrate; 1013: color filter; 1014: upper polarizer;
1051: fitting part; 1052: elongated part;
105A: inclined surface; 105B: groove;
1061: first part; 1062: second part;
106A: first segment; 106B: second segment; 106C: third segment; 106D: connecting segment;
1062A: first end; and 1062B: second end.

### DESCRIPTION OF EMBODIMENTS

An embodiment of this application provides a display apparatus. The display apparatus may be a television, an ultra-mobile personal computer (ultra-mobile personal computer, UMPC), a netbook, a personal digital assistant (personal digital assistant, PDA), a tablet computer (pad), a notebook computer, a vehicle-mounted display device, or the like. A specific form of the display apparatus is not specially limited in embodiments of this application.

In some examples, a screen size of the display apparatus may be greater than or equal to 14 inches. For example, the display apparatus may be a 50-inch television or a larger-inch television or screen. The television may be a smart large screen.

FIG. 2 is an example of a structural diagram in which a display apparatus 100 is a television. The display apparatus 100 includes a display structure 101, and the display structure 101 may include a display. The display may be a liquid crystal display (liquid crystal display, LCD) panel, or may be a self-luminous display. When the display is a self-luminous display, the display may be, for example, an organic light-emitting diode (organic light-emitting diode, OLED) display or a quantum dot light-emitting diode (quantum dot light-emitting diode, QLED) display. When the display is a liquid crystal display, the display apparatus 100 may be referred to as a liquid crystal display apparatus. When the display is a self-luminous display, the display apparatus 100 may be referred to as a self-luminous display apparatus.

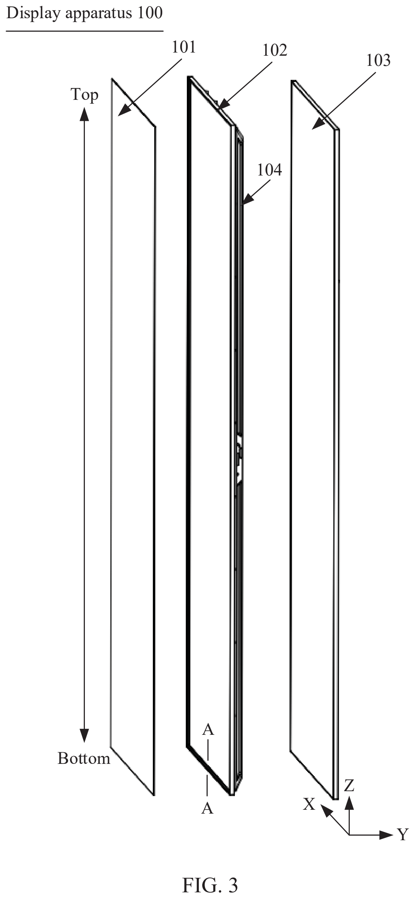

FIG. 3 is a schematic exploded view of the display apparatus 100 according to an embodiment of this application. The display apparatus 100 further includes a frame assembly 102, a backplane 104, and a rear cover 103. The display structure 101 and the rear cover 103 are disposed on two opposite sides of the frame assembly 102. As a framework and a carrier of the entire display apparatus, the backplane 104 may be mounted with components such as most mechanical parts and electronic components of the display apparatus, for example, may be mounted with various functional components such as a controller, a processor, a field output integration block, a switching power supply block, a speaker, and a picture tube.

To meet a large-screen requirement of people for a display, and implement a narrow frame and a high screen-to-body ratio, in an example, a size d of a bottom frame in a frame assembly may be reduced, as shown in FIG. 2.

To reduce a frame size and increase a screen-to-body ratio, this application provides some implementable structures as examples, as described below.

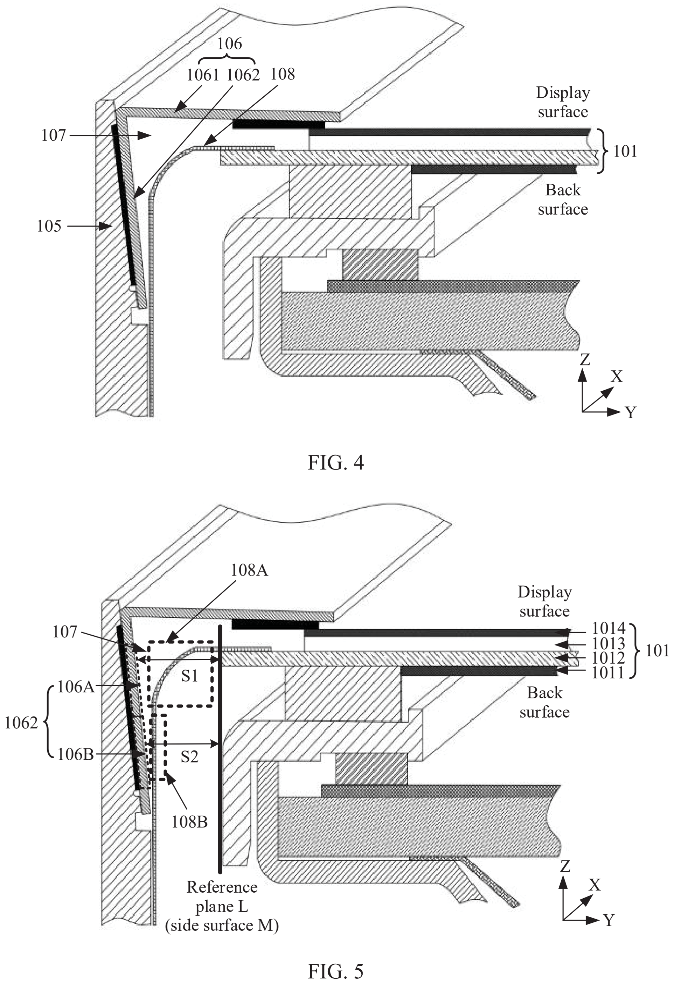

FIG. 4 is a cross-sectional view of a partial structure of a display apparatus in an example of this application. For example, the cross-sectional view may be a cross-sectional view along A-A shown in FIG. 3.

As shown in FIG. 4, in this example, the display structure 101, the frame 105, and the cover plate 106 are included. The frame 105 is disposed on a periphery of the display structure 101. For example, the frame 105 may be the bottom frame shown in FIG. 2 and FIG. 3. The bottom frame and remaining frames (such as a side frame and a top frame) in the frame assembly enclose the periphery of the display structure 101, to provide an external frame for the display structure 101.

In some display apparatuses, a material of the bottom frame may be different from a material of the remaining frame. For example, in some scenarios, the bottom frame needs to be disposed on a support surface. Therefore, mechanical strength of the bottom frame needs to be greater than mechanical strength of the remaining frame. For example, the bottom frame may be made of aluminum alloy.

As shown in FIG. 4, the cover plate 106 includes a first part 1061 and a second part 1062 that are connected. The first part 1061 is located on a side of a display surface of the display structure 101, and the second part 1062 is disposed opposite to the frame 105.

The display structure 101 has the display surface and a back surface, and the display surface is a surface in which a user can view a picture.

The first part 1061 of the cover plate 106 is disposed on the side of the display surface. The cover plate located on the side of the display surface may protect the display structure. In addition, the first part 1061 of the cover plate 106 may be further used as a decorative part.

The second part 1062 of the cover plate 106 is located on an inner side of the frame 105, and is disposed opposite to the frame 105.

In some examples, the first part 1061 and the second part 1062 may be an integrally formed mechanical part.

Alternatively, in some other examples, the first part 1061 and the second part 1062 are two mechanical parts independent of each other. In some instances, the first part 1061 and the second part 1062 may be connected through a connection structure. For example, the first part 1061 may be fastened to the second part 1062 through an adhesive layer or a threaded connector.

As shown in FIG. 4, in this example, the frame 105 and the cover plate 106 are two mechanical parts independent of each other. In some other examples, the frame 105 and the cover plate 106 may be an integrally formed part.

Materials of the frame 105 and the cover plate 106 may be the same or different. For example, the frame 105 may be made of aluminum alloy, and the cover plate 106 may be made of stainless steel.

In some display apparatuses, as shown in FIG. 4, there is space 107 on inner sides of the first part 1061 and the second part 1062 of the cover plate 106. The space 107 may accommodate some mechanical parts in the display apparatus, for example, a circuit board 108 connected to the display structure 101.

The circuit board 108 electrically connected to the display structure 101 needs to transmit an electrical signal of the display structure 101 to a main board of the display apparatus, so that a control apparatus on the main board applies a control signal to the display apparatus.

In some examples, the main board of the display apparatus may be disposed on the backplane. As shown in FIG. 4, the circuit board 108 is bent in the space 107, extends in a direction away from the back surface of the display structure 101, and is electrically connected to the main board, to implement signal interworking between the display structure 101 and the main board.

It may also be understood as that the space 107 may be used as space for avoiding a mechanical part (for example, the circuit board) in the display apparatus. In some structures, for example, when the circuit board is disposed, there is a design requirement on the avoidance space 107. For example, as shown in FIG. 4, a bent part of the circuit board 108 has sufficient space, to ensure a bending radius and a safety clearance, avoid interference with another mechanical part, and avoid affecting use performance of the circuit board.

To make the avoidance space 107 meet the requirement, as shown in FIG. 5, the second part 1062 of the cover plate 106 may include a first segment 106A and a second segment 106B. Space for avoiding a mechanical part, for example, the circuit board 108, is formed between the first segment 106A and a reference plane L and between the second segment 106B and the reference plane L. The reference plane L is perpendicular to the display surface of the display structure 101.

In addition, a spacing S1 between the first segment 106A and the reference plane L is greater than a spacing S2 between the second segment 106B and the reference plane L.

In this example of this application, the spacing S1 between the first segment 106A and the reference plane L may be understood as a spacing between the reference plane L and a wall surface that is of the first segment 106A and that faces the inside of the display apparatus; and the spacing S2 between the second segment 106B and the reference plane L may be understood as a spacing between the reference plane L and a wall surface that is of the second segment 106B and that faces the inside of the display apparatus.

In some examples, as shown in FIG. 5, the space between the first segment 106A and the reference plane L may accommodate a bent part 108A of the circuit board 108, and the space between the second segment 106B and the reference plane L may accommodate an extended part 108B of the circuit board 108. The bent part 108A includes an arc-shaped bent segment of the circuit board, and the extended part 108B includes at least a part that extends in the direction away from the back surface of the display structure 101.

FIG. 5 roughly illustrates the bent part 108A and the extended part 108B of the circuit board 108. The bent part 108A and the extended part 108B in the example do not constitute an absolute limitation on positions of the two parts.

In this example of this application, the bent part 108A is disposed in the large space between the first segment 106A and the reference plane L. In this way, sufficient bending space can be provided for the bent part 108A. In the sufficient avoidance space, it is ensured that the bent part 108A has a large bending radius and a large safety clearance, to avoid interference with another mechanical part when the circuit board is bent, or avoid a scratch between the bent part 108A and another mechanical part when the display apparatus is used.

In some structures, a side surface M of the display structure 101 may be used as the reference plane L, and the side surface M may be perpendicular to the display surface of the display structure 101.

In some possible implementations, the display structure 101 includes a light source, a lower polarizer 1011, an upper polarizer 1014, a substrate 1012 on which a plurality of thin film transistors are disposed, and a color filter 1013.

The light source projects light. The light passes through the lower polarizer 1011, and then passes through the thin film transistor. Next, the light further needs to pass through the color filter 1013 and the upper polarizer 1014.

In some examples, as shown in FIG. 5, an edge of the substrate 1012 on which the plurality of thin film transistors are disposed is more protruding than another film layer structure because the circuit board 108 needs to be bound (which may also be referred to as connected). A bonding (bonding) area is disposed on the edge of the substrate 1012 on which the plurality of thin film transistors are disposed, and the circuit board 108 is connected to the bonding area.

A side surface of the substrate 1012 on which the plurality of thin film transistors are disposed may be shown as the reference plane L.

As shown in FIG. 5, the first segment 106A and the second segment 106B that are included in the second part 1062 of the cover plate 106 may be disposed in a direction from the display surface to the back surface. In other words, the first segment 106A and the second segment 106B are sequentially disposed in the direction from the display surface to the back surface.

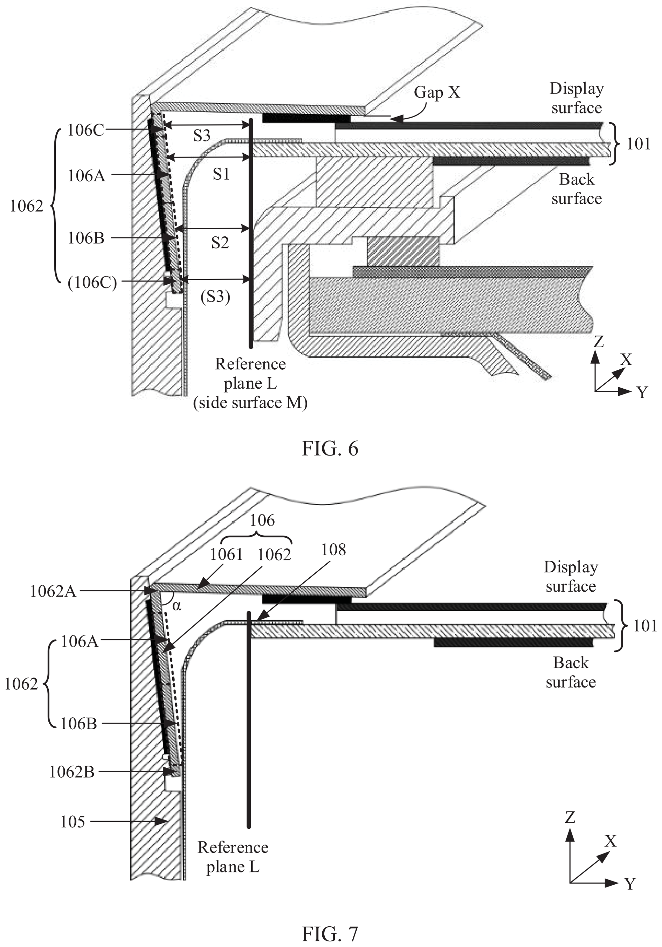

In some examples, as shown in FIG. 6, the second part 1062 may further include a third segment (106C). The first segment 106A, the second segment 106B, and the third segment (106C) may be sequentially disposed in the direction from the display surface to the back surface. Alternatively, the first segment 106A, the third segment (106C), and the second segment 106B may be sequentially disposed in the direction from the display surface to the back surface. Alternatively, as shown in FIG. 6, the third segment 106C, the first segment 106A, and the second segment 106B may be sequentially disposed in the direction from the display surface to the back surface.

When the second part further includes the third segment 106C, as shown in FIG. 6, the third segment 106C, the first segment 106A, and the second segment 106B may be sequentially disposed in the direction from the display surface to the back surface. A spacing S3 between the third segment 106C and the reference plane L may be greater than the spacing S1 between the first segment 106A and the reference plane L. Alternatively, the first segment 106A, the second segment 106B, and the third segment (106C) may be sequentially disposed in the direction from the display surface to the back surface. A spacing (S3) between the third segment 106C and the reference plane L may be less than the spacing S2 between the second segment 106B and the reference plane L. For example, the extended part 108B of the circuit board 108 may continue to extend into space between the third segment (106C) and the reference plane L.

As shown in FIG. 6, when the display apparatus is assembled, a mounting position of the cover plate 106 may be adjusted upward and downward (for example, in a direction Z in FIG. 6). In some structures, a designed gap X between the display surface of the display structure 101 and the first part 1061 of the cover plate 106 is different. For example, a designed gap X between a display surface of some display structures 101 and the first part 1061 is large, and a designed gap X between a display surface of some other display structures 101 and the first part 1061 is small.

In this application, a position of the cover plate 106 may be adjusted upward and downward, to meet a gap X requirement of different screens and match different displays.

To ensure that the spacing S1 between the first segment 106A and the reference plane L is greater than the spacing S2 between the second segment 106B and the reference plane L, this application provides a plurality of implementable structures.

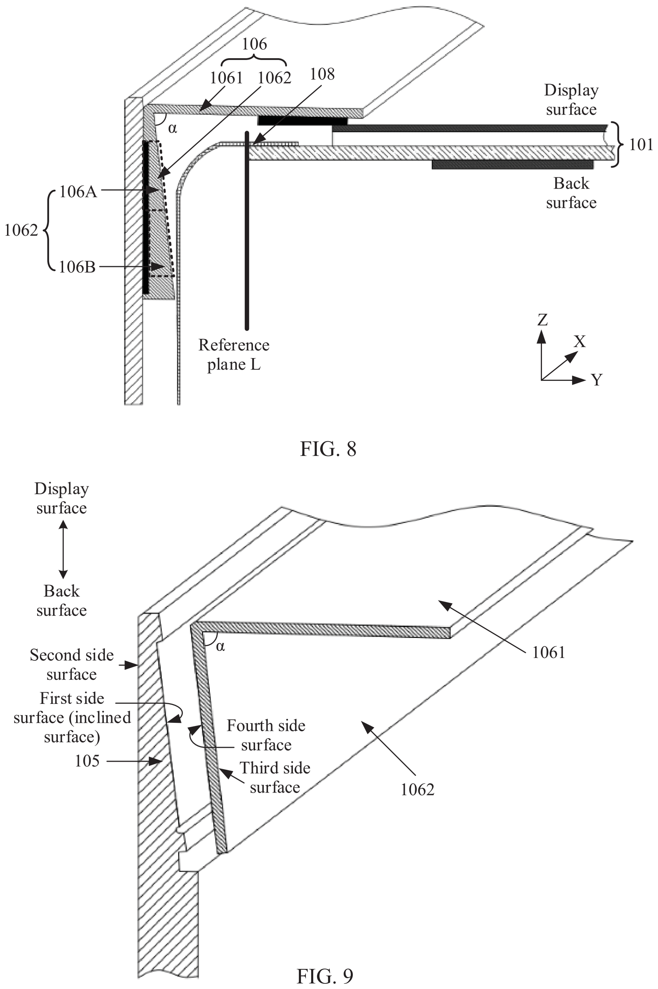

FIG. 7 and FIG. 8 show two different structures of the frame 105 and the cover plate 106.

In two different examples in FIG. 7 and FIG. 8, an included angle α between the first part 1061 and the second part 1062 is less than 90°, the first segment 106A and the second segment 106B are consecutive segments of the second part 1062, and the first segment 106A is closer to the first part 1061 than the second segment 106B.

It may be understood as follows: In FIG. 7 and FIG. 8, in the direction from the display surface to the back surface, the second part 1062 gradually inclines toward the inside of the display apparatus, so that the spacing S2 between the second segment 106B and the reference plane L is less than the spacing S1 between the first segment 106A and the reference plane L.

FIG. 9 is an exploded view of the frame 105 and the cover plate 106 in the example in FIG. 7. The frame 105 has a first side surface and a second side surface that are opposite to each other. With reference to FIG. 9 and FIG. 7, the first side surface is closer to the second part 1062 of the cover plate 106 than the second side surface.

As shown in FIG. 9, a distance between the first side surface and the second side surface decreases in a direction from the back surface of the display structure to the display surface, so that the first side surface is an inclined surface, and the second part 1062 of the cover plate 106 is disposed at an angle on the first side surface, so that the spacing S1 between the first segment 106A and the reference plane L is greater than the spacing S2 between the second segment 106B and the reference plane L.

In this example, the frame 105 is in a wedge-shaped structure, and a width of a user-visible part is small. To fit with the wedge-shaped frame 105, as shown in FIG. 9, the included angle α between the first part 1061 and the second part 1062 of the cover plate 106 is less than 90°.

Still as shown in FIG. 9, a second part 1062 of the cover plate 106 includes a third side surface and a fourth side surface. The third side surface and the fourth side surface are parallel to each other, or are approximately parallel to each other due to factors such as process manufacturing. The fourth side surface is closer to the frame 105 than the third side surface. In other words, the fourth side surface of the cover plate 106 and the first side surface of the frame 105 are disposed opposite to each other.

In the display apparatus, as shown in FIG. 7, a smaller distance between the frame 105 and the user-visible top indicates a smaller force on the frame. In this application, the frame 105 is in a wedge-shaped structure, and a wider lower part can support the force on the frame. In addition, the top of the frame is narrow, so that the frame can achieve a narrow frame effect. Therefore, as shown in FIG. 7, this application can not only implement a narrow frame and a large screen-to-body ratio of the entire display apparatus, but also achieve a narrow frame effect of the frame, to implement a dual narrow frame of the display apparatus, and further optimize appearance aesthetics.

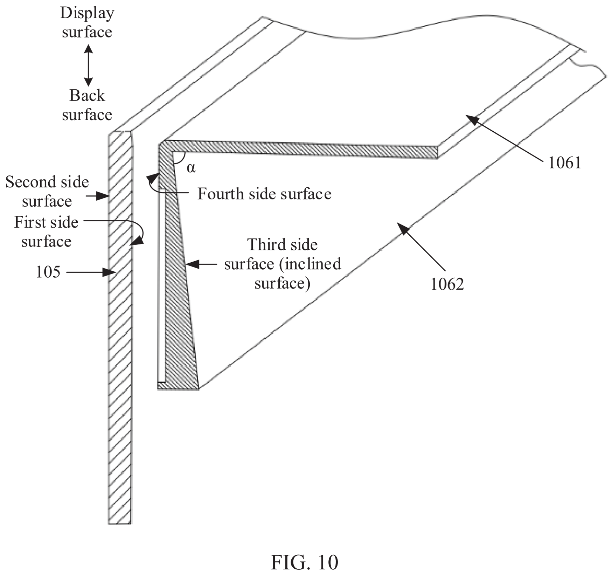

FIG. 10 is an exploded view of the frame 105 and the cover plate 106 in the example in FIG. 8. In this implementation structure, a distance between the third side surface and the fourth side surface of the second part 1062 of the cover plate 106 decreases in the direction from the back surface of the display structure to the display surface, so that the third side surface is an inclined surface, and the spacing between the first segment and the reference plane is greater than the spacing between the second segment and the reference plane. In other words, in this example, the second part 1062 of the cover plate 106 is in a wedge-shaped structure.

Still as shown in FIG. 10, the first side surface and the second side surface of the frame 105 are parallel to each other.

In different examples shown in FIG. 9 and FIG. 10, regardless of whether the frame 105 is designed as a wedge-shaped structure or the second part 1062 of the cover plate 106 is designed as a wedge-shaped structure, avoidance space with different spacings may be formed between different segments of the second part 1062 and the reference plane, to ensure that the circuit board 108 meets an assembly process requirement.

To improve appearance aesthetics of the display apparatus and reduce the frame size, as shown in FIG. 7 and FIG. 8, a user-visible cover plate part is attached to a frame part. In some assembly structures, there is a small assembly tolerance between the user-visible cover plate part and the frame part, so that there is a small gap. For example, the gap may be less than or equal to 0.125 mm.

Alternatively, it may be understood as follows: As shown in FIG. 7, the second part 1062 of the cover plate 106 includes a first end 1062A connected to the first part 1061 and a second end 1062B opposite to the first end 1062A. A side surface that is of the first end 1062A and that faces the frame 105 is attached to the frame 105.

In some examples, both the first segment 106A and the second segment 106B are located between the first end 1062A and the second end 1062B, and the first segment 106A is closer to the first end 1062A than the second segment 106B.

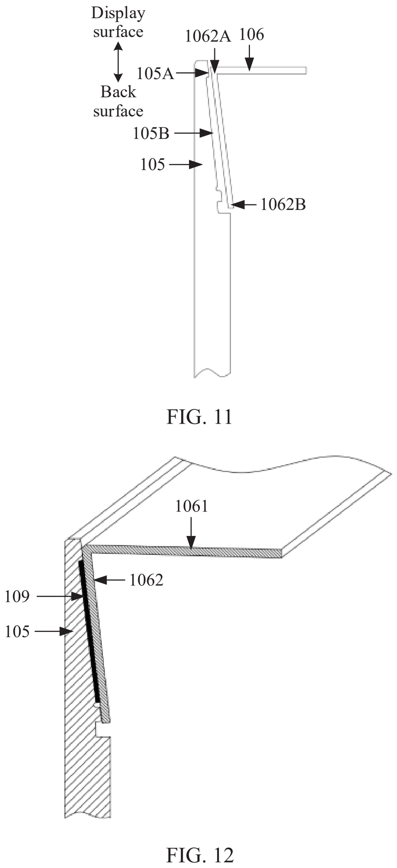

To further improve appearance aesthetics of the display apparatus, FIG. 11 is an exploded view of the frame 105 and the cover plate 106. A surface that is of the frame 105 and that is attached to a first end of the cover plate 106 is an inclined surface 105A. In the direction from the back surface of the display structure to the display surface, the inclined surface 105A that is of the frame and that is attached to the first end inclines in a direction away from a side surface of the display structure. Alternatively, it may be understood as follows: In the direction from the display surface of the display structure to the back surface, the inclined surface 105A inclines toward the inside of the display apparatus.

The surface that is of the frame 105 and that is attached to the first end of the cover plate 106 is designed as an inclined surface. In this way, even if there is a design tolerance or an assembly tolerance, the frame 105 is basically attached to the cover plate 106 when viewed from an appearance of the display apparatus, so that a visual effect of a gap can be weakened, and appearance aesthetics can be improved.

In some examples, when the frame 105 and the cover plate 106 are two mechanical parts independent of each other, the frame 105 and the cover plate 106 may be connected through a connection structure.

FIG. 12 is a diagram of an example of a connection relationship between the frame 105 and the cover plate 106. The second part 1062 of the cover plate 106 may be connected to the frame 105. For example, the frame 105 may be bonded to the second part 1062 of the cover plate 106 through an adhesive layer 109.

In this example of this application, the adhesive layer 109 is disposed in a hidden manner. As shown in FIG. 12, the adhesive layer 109 is disposed on a side that is away from the frame 105 and that is attached to the cover plate 106. In this way, the adhesive layer 109 is invisible when viewed from the appearance of the display apparatus, so that appearance aesthetics of the display apparatus can be further optimized.

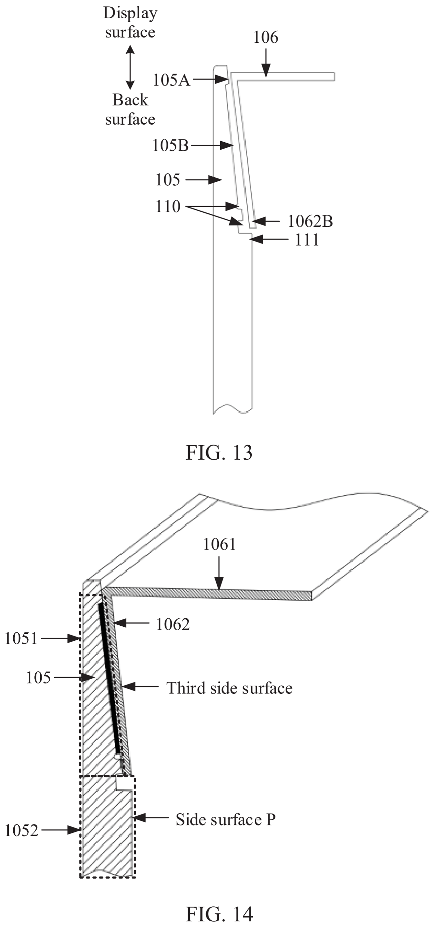

As shown in FIG. 13, to reduce the frame size of the display apparatus and increase the screen-to-body ratio, in some structures, a groove 105B may be disposed at a position that is of the frame 105 and that is opposite to the second part 1062 of the cover plate 106, and the adhesive layer 109 is disposed in the groove 105B. Alternatively, a groove may be disposed on the second part 1062 of the cover plate 106, and the adhesive layer 109 is disposed in the groove of the cover plate.

In some examples, the adhesive layer 109 may be manufactured by using a bonding process. For example, the cover plate 106 and the frame 105 may be bonded through a double-sided tape. In this way, manufacturing costs can be further reduced. Alternatively, in some other examples, the adhesive layer 109 may be manufactured by using a glue coating process.

In an implementable process, to prevent liquid glue from overflowing from the groove 105B, as shown in FIG. 13, a glue overflow groove 110 is disposed on a bottom surface that is of the groove 105B and that is opposite to the second part 1062.

A plurality of glue overflow grooves 110 may be disposed, and the plurality of glue overflow grooves 110 may be spaced from each other in an extension direction of the groove 105B. For example, in FIG. 13, two glue overflow grooves 110 are disposed.

A shape and a size of the glue overflow groove 110 are not specially limited in this application. For example, an arc-shaped groove or a rectangular groove may be used.

In some processes, for example, when the cover plate 106 and the frame 105 are bonded through a double-sided tape, a thickness of the double-sided tape is greater than a depth of the groove 105B. After pressure is applied, it is ensured that an exposed part of the cover plate 106 is closely attached to an exposed part of the frame 105 after an adhesive layer is compressed, to improve appearance aesthetics of the display apparatus.

Still as shown in FIG. 13, a boss 111 is formed on a side surface that is of the frame 105 and that faces the inside of the display apparatus, and a second end of the second part 1062 of the cover plate 106 is located above the boss 111. The boss 111 may be used to limit a lower limit position of the cover plate 106 during mounting. This prevents some components in the display apparatus from being damaged due to a large mounting deviation of the cover plate 106, for example, can reduce a risk of damage to the circuit board.

In some examples, as shown in FIG. 14, the frame 105 not only includes a fitting part 1051 opposite to the cover plate 106, but also includes an elongated part 1052 connected to the fitting part 1051. The elongated part 1052 may be connected to another mechanical part, for example, may be connected to a rear cover of the display apparatus. A side surface P that is of the elongated part 1052 and that faces the inside of the display apparatus is more protruding than a third side surface that is of the second part 1062 of the cover plate 106 and that faces the inside of the display apparatus.

For example, the avoidance space in this example of this application is to avoid mounting space for the circuit board 108. The circuit board 108 is likely to be scratched by a surrounding mechanical part. Therefore, in the example in FIG. 14, the circuit board 108 may be connected to the rear cover of the display apparatus, and a side surface that is of the elongated part 1052 and that faces the inside of the display apparatus is more protruding than a side surface that is of the second part 1062 of the cover plate 106 and that faces the inside of the display apparatus. In this way, the circuit board 108 can be less likely to be scratched by the cover plate 106 or the frame 105 with high hardness.

As shown in FIG. 14, in this example, the side surface P of the elongated part 1052 is a vertical surface. In some other examples, the side surface P of the elongated part 1052 may alternatively be an inclined surface.

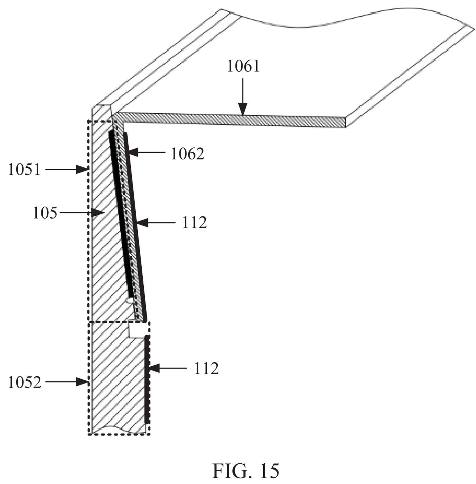

To further protect the circuit board 108, as shown in FIG. 15, a protective layer 112 may be disposed on the side surface that is of the second part 1062 of the cover plate 106 and that faces the inside of the display apparatus; or a protective layer 112 may be disposed on the side surface that is of the elongated part 1052 of the frame 105 and that faces the inside of the display apparatus; or a protective layer 112 may be disposed on the side surface that is of the second part 1062 of the cover plate 106 and that faces the inside of the display apparatus, and a protective layer 112 may be disposed on the side surface that is of the elongated part 1052 of the frame 105 and that faces the inside of the display apparatus.

The protective layer 112 may be used to reduce a risk of scratching the circuit board 108 by the cover plate or the frame, and increase a yield of the display apparatus.

The protective layer 112 may be made of a plurality of materials, for example, at least one of Mylar, foam, or a rubber strip.

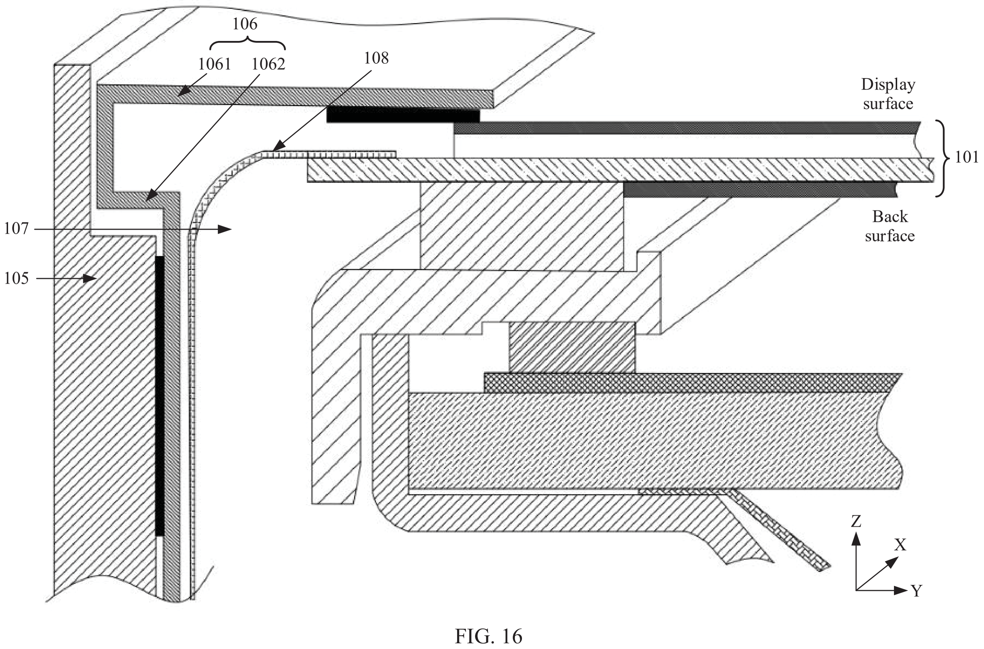

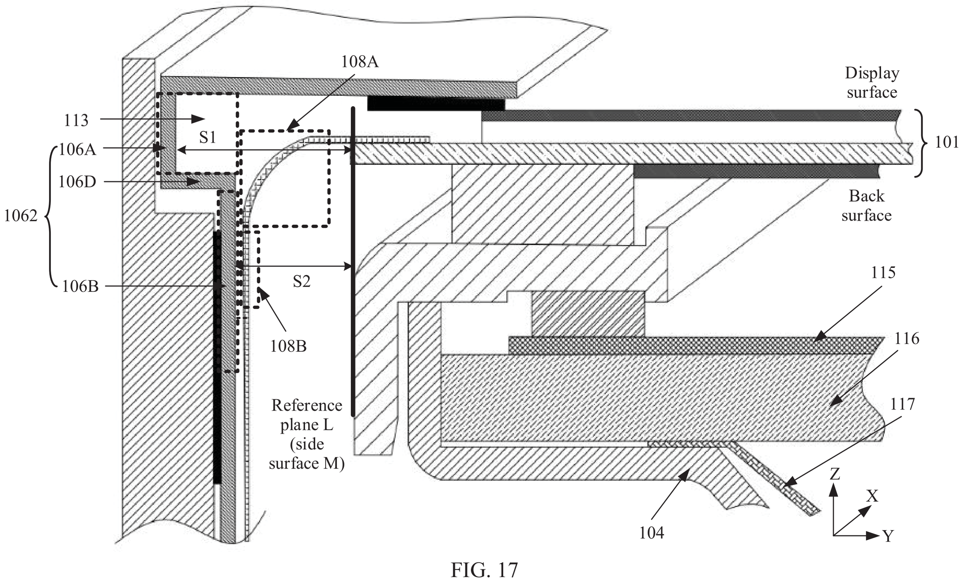

FIG. 16 and FIG. 17 show another implementation structure that can provide space for avoiding a mechanical part (for example, a circuit board 108) in a display apparatus according to an embodiment of this application. In this example, a frame 105 and a cover plate 106 are included, and the cover plate 106 includes a first part 1061 and a second part 1062 that are connected. The first part 1061 is located on a side of a display surface of a display structure 101, and the second part 1062 is disposed opposite to the frame 105.

There is space 107 between the first part 1061 and the second part 1062 of the cover plate 106, and the space 107 may accommodate a mechanical part like the circuit board 108.

As shown in FIG. 17, the second part 1062 of the cover plate 106 includes a first segment 106A and a second segment 106B. The first segment 106A and the second segment 106B are nonconsecutive. Further, the second part 1062 further includes a connecting segment 106D, and the connecting segment 106D connects the first segment 106A and the second segment 106B.

In the example in FIG. 17, the first segment 106A is closer to the first part 1061 of the cover plate than the second segment 106B. A first concave cavity 113 is formed at a position of the first segment 106A of the cover plate 106, and the space 107 may be widened by using the concave cavity, so that a spacing S1 between the first segment 106A and a reference plane L is greater than a spacing S2 between the second segment 106B and the reference plane L. In this example, the reference plane L is a plane perpendicular to the display surface of the display structure 101.

For an explanation of the reference plane L in this example, refer to the reference plane L in the foregoing example.

In this embodiment, the spacing S1 between the first segment 106A and the reference plane L may be understood as a spacing between the reference plane L and a surface that is of the first concave cavity 113 and that faces the inside of the display apparatus; and the spacing S2 between the second segment 106B and the reference plane L may be understood as a spacing between the reference plane L and a surface that is of the second segment 106B and that faces the inside of the display apparatus.

As shown in FIG. 17, space between the first segment 106A and the reference plane L can provide space for avoiding a bent part 108A of the circuit board 108, and space between the second segment 106B and the reference plane L can provide space for avoiding an extended part 108B of the circuit board 108.

A concave cavity is disposed at a position of the first segment 106A, so that large space is provided between the first segment 106A and the reference plane L. In this way, sufficient bending space can be provided for the circuit board 108, to ensure that the bending space meets a safety clearance requirement.

In some examples, the space between the second segment 106B and the reference plane L may avoid at least a part of the extended part 108B of the circuit board 108.

Refer to FIG. 17. A second concave cavity 114 is formed at a position that is of the frame 105 and that corresponds to the first segment 106A, and the first segment 106A is located in the second concave cavity 114.

As shown in FIG. 17, the second concave cavity 114 is disposed on the frame 105, so that a width of a user-visible part of the frame 105 is narrow. In this way, the frame can achieve a narrow frame effect. Therefore, as shown in FIG. 17, this application can not only implement a narrow frame and a large screen-to-body ratio of the entire display apparatus, but also achieve a narrow frame effect of the frame, to implement a dual narrow frame of the display apparatus, and further optimize appearance aesthetics.

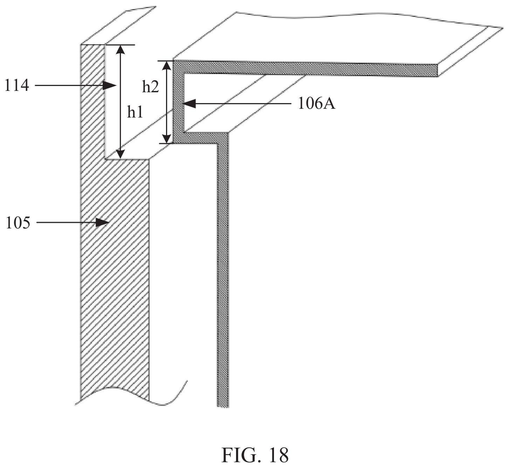

FIG. 18 is a schematic exploded view of the frame 105 and the cover plate 106. In this example, a height h1 of the second concave cavity 114 disposed on the frame 105 is greater than a height h2 of the first segment 106A of the cover plate 106.

In this way, a mounting position of the cover plate 106 may be adjusted upward and downward when the cover plate 106 is mounted, to meet a gap X requirement of different screens and match different displays.

The height h1 of the second concave cavity 114 and the height h2 of the first segment 106A may be understood as dimensions in a direction perpendicular to the display surface of the display structure, or may be dimensions in a direction parallel to the reference plane L.

In the example in FIG. 16 and FIG. 17, the second segment 106B of the cover plate 106 may be connected to the frame 105 through an adhesive layer 109. In this way, a hidden connection structure is used in this example, and is invisible to a user, so that appearance aesthetics can be improved.

In some examples, a groove may be disposed at a position that is of the frame 105 and that is opposite to the second segment 106B, and the adhesive layer 109 is disposed in the groove. Alternatively, a groove may be disposed on the second segment 106B of the cover plate 106, and the adhesive layer 109 is disposed in the groove.

In some other examples, the frame 105 and the cover plate 106 may alternatively be of an integrated structure.

To protect the circuit board 108, a protective layer may be disposed on a side surface that is of the second segment 106B of the cover plate 106 and that faces the circuit board 108. A protective layer may also be disposed on a side surface that is of the frame 105 and that faces the circuit board 108.

The protective layer may be made of a plurality of materials, for example, at least one of Mylar, foam, or a rubber strip. When the protective layer is made of Mylar, the protective layer is thin and does not occupy large space.

As shown in FIG. 17, the display apparatus in this example of this application may further include a light source and an optical structure for processing light of the light source. The light emitted by the light source may be processed by the optical structure and then projected to the user through the display structure 101, to display a picture.

For example, the optical structure may be one or a combination of a reflector 117, a diffuser 116, a light enhancement sheet 115, or a prism. A main function of the optical structure is to fully diffuse or aggregate light passing through the optical structure, increase light utilization, make a point light source become a surface light source, or the like, to improve a display effect.

A backplane 104 used as a bearing frame of the entire display apparatus may be configured to support the optical structure.

The foregoing provides several possible design solutions in this application with reference to the accompanying drawings. In some other possible examples covered in this application, a plurality of mechanical parts that need to be avoided may alternatively be included inside the display. In this case, a multi-segment avoidance design may be used with reference to a similar solution provided in this application, to provide avoidance space for each of the plurality of mechanical parts, so that a narrow frame design of the display apparatus is implemented while safety clearance space is provided for the plurality of mechanical parts.

In the descriptions of this specification, specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display apparatus, comprising:
a display structure;
a frame, wherein the frame is disposed on a periphery of the display structure; and
a cover plate, wherein the cover plate comprises a first part and a second part that are connected, the first part is located on a side of a display surface of the display structure, and the second part is disposed opposite to the frame;
the second part comprises a first segment and a second segment;
space for avoiding a mechanical part is formed between the first segment and a reference plane and between the second segment and the reference plane;
a spacing between the first segment and the reference plane is greater than a spacing between the second segment and the reference plane; and
a plane perpendicular to the display surface of the display structure is the reference plane.

2. The display apparatus according to claim 1, wherein the first segment and the second segment are consecutive segments of the second part, the first segment is closer to the first part than the second segment, and an included angle between the first part and the second part is less than 90°.

3. The display apparatus according to claim 2, wherein the frame comprises a first side surface and a second side surface that are opposite to each other, and the first side surface is closer to the second part than the second side surface; and
a distance between the first side surface and the second side surface decreases in a direction from a back surface of the display structure to the display surface, so that the first side surface is an inclined surface, and the second part is disposed at an angle on the inclined surface, so that the spacing between the first segment and the reference plane is greater than the spacing between the second segment and the reference plane.

4. The display apparatus according to claim 3, wherein the second part comprises a third side surface and a fourth side surface that are opposite to each other, and the third side surface is parallel to the fourth side surface.

5. The display apparatus according to claim 2, wherein the second part comprises a third side surface and a fourth side surface that are opposite to each other, and the fourth side surface is closer to the frame than the third side surface; and
a distance between the third side surface and the fourth side surface decreases in a direction from a back surface of the display structure to the display surface, so that the third side surface is an inclined surface, and the spacing between the first segment and the reference plane is greater than the spacing between the second segment and the reference plane.

6. The display apparatus according to claim 5, wherein the frame comprises a first side surface and a second side surface that are opposite to each other, and the first side surface is parallel to the second side surface.

7. The display apparatus according to any one of claims 2 to 6, wherein the second part comprises a first end connected to the first part and a second end opposite to the first end, and both the first segment and the second segment are located between the first end and the second end; and
a side surface that is of the first end and that faces the frame is attached to the frame.

8. The display apparatus according to claim 7, wherein in the direction from the back surface of the display structure to the display surface, a surface that is of the frame and that is attached to the first end inclines in a direction away from a side surface of the display structure.

9. The display apparatus according to claim 7 or 8, wherein the display apparatus further comprises an adhesive layer, the adhesive layer connects the frame to the second part, and the adhesive layer is disposed on a side that is away from the frame and that is attached to the cover plate.

10. The display apparatus according to claim 9, wherein a groove is disposed at a position that is of the frame and that is opposite to the second part, and the adhesive layer is located in the groove.

11. The display apparatus according to claim 10, wherein a glue overflow groove is disposed on a bottom surface that is of the groove and that is opposite to the second part.

12. The display apparatus according to any one of claims 7 to 11, wherein a boss is formed on a side surface that is of the frame and that faces the mechanical part, and the second end of the second part is located above the boss.

13. The display apparatus according to any one of claims 2 to 12, wherein the frame comprises a fitting part opposite to the second part, and further comprises an elongated part connected to the fitting part, and a side surface that is of the elongated part and that faces the mechanical part protrudes relative to a side surface that is of the second part and that faces the mechanical part.

14. The display apparatus according to claim 13, wherein there is a protective layer on the side surface that is of the second part and that faces the mechanical part and/or the side surface that is of the elongated part and that faces the mechanical part.

15. The display apparatus according to claim 1, wherein the first segment and the second segment are nonconsecutive segments of the second part, the first segment and the second segment are connected through a connecting segment, and the first segment is closer to the first part than the second segment; and
a first concave cavity is formed at a position of the first segment of the cover plate, so that the spacing between the first segment and the reference plane is greater than the spacing between the second segment and the reference plane.

16. The display apparatus according to claim 15, wherein a second concave cavity is formed at a position that is of the frame and that corresponds to the first segment, and the first segment is located in the second concave cavity.

17. The display apparatus according to claim 15 or 16, wherein the display apparatus further comprises an adhesive layer, and the adhesive layer connects the second segment to the frame.

18. The display apparatus according to any one of claims 1 to 17, wherein the mechanical part comprises a circuit board, the circuit board is located on an inner side of the cover plate, the circuit board is connected to the display structure, the circuit board bends and extends toward the back surface of the display structure, and the space between the first segment and the reference plane and between the second segment and the reference plane is for avoiding the circuit board.

19. The display apparatus according to any one of claims 1 to 18, wherein the frame is a bottom frame.

20. A frame assembly, wherein the frame assembly is configured to be disposed in a display apparatus, and the frame assembly comprises:
a frame, wherein the frame is configured to be disposed on a periphery of a display structure of the display apparatus; and
a cover plate, wherein the cover plate comprises a first part and a second part that are connected, the first part is configured to be disposed on a side of a display surface of the display structure, the second part is disposed opposite to the frame, an included angle between the first part and the second part is less than 90°, the second part comprises a first segment and a second segment, the first segment and the second segment are consecutive segments of the second part, and space for avoiding a mechanical part in the display apparatus is formed between the first segment and a reference plane and between the second segment and the reference plane;
a spacing between the first segment and the reference plane is greater than a spacing between the second segment and the reference plane; and
a plane perpendicular to the display surface of the display structure is the reference plane.

21. The frame assembly according to claim 20, wherein the frame comprises a first side surface and a second side surface that are opposite to each other, and the first side surface is closer to the second part than the second side surface; and
a distance between the first side surface and the second side surface decreases in a direction from a back surface of the display structure to the display surface, so that the first side surface is an inclined surface, and the second part is disposed at an angle on the inclined surface, so that the spacing between the first segment and the reference plane is greater than the spacing between the second segment and the reference plane.

22. The frame assembly according to claim 21, wherein the second part comprises a first end connected to the first part and a second end opposite to the first end, and both the first segment and the second segment are located between the first end and the second end; and
a side surface that is of the first end and that faces the frame is attached to the frame.

23. The frame assembly according to claim 22, wherein the frame assembly further comprises an adhesive layer, the adhesive layer connects the frame to the second part, and the adhesive layer is disposed on a side that is away from the frame and that is attached to the cover plate.

24. The frame assembly according to claim 23, wherein a groove is disposed at a position that is of the frame and that is opposite to the second part, and the adhesive layer is located in the groove.

25. A frame assembly, wherein the frame assembly is configured to be disposed in a display apparatus, and the frame assembly comprises:
a frame, wherein the frame is configured to be disposed on a periphery of a display structure of the display apparatus; and
a cover plate, wherein the cover plate comprises a first part and a second part that are connected, the first part is configured to be disposed on a side of a display surface of the display structure, the second part is disposed opposite to the frame, the second part comprises a first segment, a second segment, and a connecting segment connecting the first segment and the second segment, and space for avoiding a mechanical part in the display apparatus is formed between the first segment and a reference plane and between the second segment and the reference plane;
a first concave cavity is formed at a position of the first segment of the cover plate, so that a spacing between the first segment and the reference plane is greater than a spacing between the second segment and the reference plane; and
a plane perpendicular to the display surface of the display structure is the reference plane.

26. The frame assembly according to claim 25, wherein a second concave cavity is formed at a position that is of the frame and that corresponds to the first segment, and the first segment is located in the second concave cavity.

27. The frame assembly according to claim 25 or 26, wherein the frame assembly further comprises an adhesive layer, and the adhesive layer connects the second segment to the frame.
